# EUROPEAN PATENT SPECIFICATION

(11) **EP 2 991 244 B1**
(45) Date of publication and mention of the grant of the patent: **24.01.2018**
(21) Application number: 15187827.9
(22) Date of filing: 16.06.2011
(51) Int. Cl.: H04B 10/071, H04B 10/564, G01M 11/00

(54) **METHOD AND APPARATUS FOR CONTROLLING OPTICAL POWER**
VERFAHREN UND VORRICHTUNG ZUR STEUERUNG EINER OPTISCHEN LEISTUNG
PROCÉDÉ ET APPAREIL POUR LE CONTRÔLE D'UNE ÉNERGIE OPTIQUE

(43) Date of publication of application: 02.03.2016
(62) Divisional of application: 11867973.7
(73) Proprietor: Huawei Technologies Co., Ltd., Longgang District Shenzhen, Guangdong 518129 (CN)
(72) Inventor: ZHONG, Degang, 518129 Shenzhen (CN); YANG, Sulin, 518129 Shenzhen (CN); LI, Shengping, 518129 Shenzhen (CN); LI, Zebin, 518129 Shenzhen (CN)
(74) Representative: Pfenning, Meinig & Partner mbB

(56) References cited:
- CA-C- 1 340 124

## Description

### FIELD OF THE INVENTION

The present application relates to communications technologies, and in particular, to a method and an apparatus for controlling optical power of a passive optical network.

### BACKGROUND OF THE INVENTION

Optical fiber cables, in replacement of copper cables, gradually become the mainstream access method of the network technology, and the application of the optical access technology develops vigorously. The passive optical network (Passive Optical Network, PON) technology is an optical access technology based on point to multi point (Point to Multi Point, P2MP). Generally speaking, a passive optical network system mainly includes an optical line terminal (Optical Line Terminal, OLT) located at a central office, a plurality of optical network units (Optical Network Unit, ONU) located at user sides, and an optical distribution network for distributing or multiplexing data signals between the optical line terminal and the optical network units.

To ensure the power budget of a network link, a data transmission part of the optical line terminal usually adopts an automatic power control (Auto Power Control, APC) loop to ensure the stability of transmitted optical power. Specifically, when the optical line terminal sends downlink data, the APC loop monitors the output optical power of the optical source in real time, and adjusts a bias current of the optical source according to a power monitoring result, thereby implementing automatic power control.

In another aspect, in a passive optical network, an optical time domain reflectometer (Optical Time Domain Reflectometer, OTDR) is widely used in aspects such as an optical fiber network test and fault location.

During an OTDR test, the passive optical network usually needs to be maintained in a working state to avoid influences on normal services, and therefore, an OTDR test signal is sent by being superimposed to normal communication data. However, after the OTDR test signal is superimposed to the communication data, fluctuations may occur on the output optical power of the optical line terminal. In this case, the APC loop automatically reduces the bias current of the optical source according to the output optical power monitoring result. Because the optical intensity of the OTDR test signal is usually relatively weak, for example, about 5%∼30% of the communication data, the automatic adjustment of the output optical power might significantly weaken the intensity of the OTDR test signal or even submerge the OTDR test signal, thereby causing that the OTDR cannot normally perform a test and fault location.
CA 1340124 C discloses a power control system for a laser which may be used in an optical time domain reflectometer. Especially, the system monitors the output light of the laser to control the bias current and pulse current to the laser.

### SUMMARY OF THE INVENTION

To solve the foregoing problem that the automatic power control weakens or even submerges the test signal, the present application provides a method and an apparatus for controlling optical power, where the apparatus for controlling optical power may specifically be an optical source driver, an optical transceiver module or an optical line terminal.

A method for controlling optical power, which includes: monitoring output optical power of an optical source, and judging whether a preset test control signal is received; when the preset test control signal is not received, modulating a data signal to output light of the optical source, and adjusting a bias current of the optical source according to an output optical power monitoring result of the optical source to implement the automatic power control; and when the preset test control signal is received, starting a test and superimposing a test signal to the data signal to form a superimposed signal, and modulating the superimposed signal to the output light of the optical source; the output optical power monitoring result of the optical source is ignored during the test period to maintain the bias current of the optical source at a preset target value; wherein the preset control signal is a valid optical time domain reflectometer, OTDR, test control signal.

An optical transceiver module includes: an optical source, an optical source driver and a test controller. The test controller is connected to the optical source driver, and is configured to provide a test signal for the optical source driver during a test period. The optical source driver is configured to acquire an output optical power monitoring result of the optical source; when a preset test control signal is not received, modulate a data signal to output light of the optical source, and adjust a bias current of the optical source according to an output optical power monitoring result to implement automatic power control; and when the preset test control signal is received, start a test and superimpose the test signal to the data signal to form a superimposed signal and modulate the superimposed signal to the output light of the optical source, and maintain the bias current of the optical source at a preset target value by ignoring the output optical power monitoring result of the optical source during the test period; and wherein the preset control signal is a valid optical time domain reflectometer, OTDR, test control signal.

An optical line terminal includes a service processing module and an optical transceiver module, where the optical transceiver module is the foregoing optical transceiver module, and the service processing module is configured to provide a preset test control signal to the optical transceiver module and collect test data and correspondingly perform fault detection after the test is completed.

In the technical solutions provided by the present application, during the test period, although that the test signal is superimposed to downlink data may cause fluctuations on the output optical power of the optical source, because the automatic power control loop is disabled under the control of the preset test control signal during the test period, the output optical power monitoring result is ignored, so that the bias current of the optical source is maintained at a preset target value. Therefore, compared with the existing techniques, the technical solutions provided by the present application may avoid the problem that the test signal is weakened in the signal strength or even submerged due to the automatic optical power adjustment effectively, thereby ensuring a normal OTDR test and fault location.

### BRIEF DESCRIPTION OF THE DRAWINGS

FIG. 1 is a schematic structure diagram of a passive optical network;
FIG. 2 is a schematic structure diagram of an optical line terminal according to an embodiment of the present application, where the optical line terminal includes an optical transceiver module;
FIG. 3 is schematic diagram of an internal structure of an optical source driver in an optical transceiver module shown in FIG. 2; and

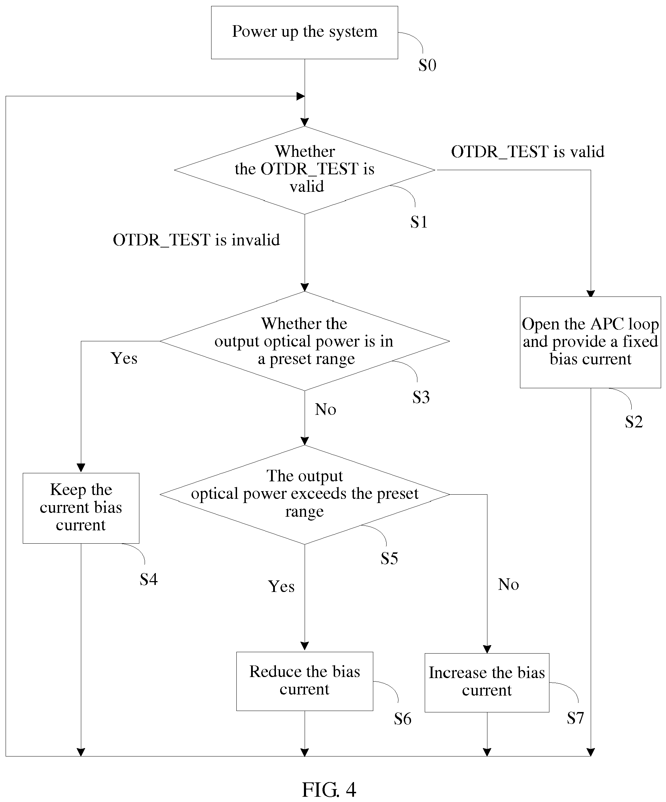

FIG. 4 is a work flow chart of an optical source driver shown in FIG. 3.

### DETAILED DESCRIPTION OF THE EMBODIMENTS

The technical solutions provided by the present application are described in detail with reference to the specific embodiments in the following.

To solve the problem that an OTDR test signal is weakened or even submerged due to the automatic power control by adopting an APC loop in the existing techniques, the present application proposes to adopt seamless switching between open-loop and closed-loop of an APC loop in an optical transceiver module of an optical line terminal to control a bias current of an optical source (for example, a laser diode), so that the bias current of the optical source of the optical transceiver module is kept unchanged during the OTDR test period, thereby ensuring the intensity of the OTDR test signal during the OTDR test, and solving the problem that the OTDR test signal might be significantly weakened or even submerged due to the automatic power control is effectively solved.

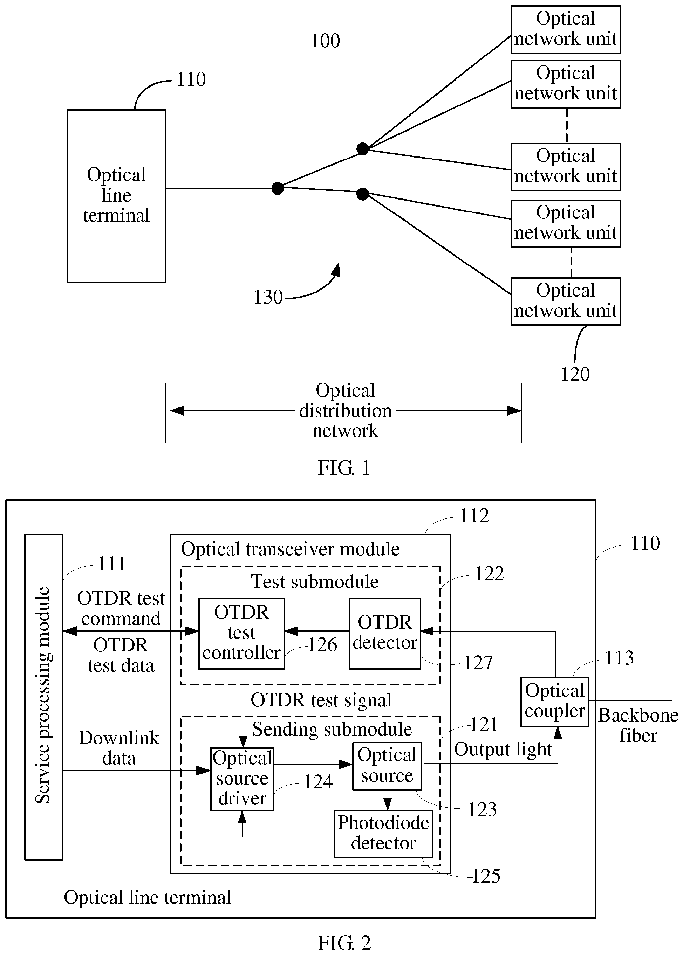

To better understand the present disclosure, the following description first introduces a structure of a passive optical network (PON) system that is applicable to the method for controlling optical power provided by the present application. Referring to FIG. 1, a passive optical network system 100 may include at least one optical line terminal 110, a plurality of optical network units 120 and an optical distribution network 130. The optical line terminal 110 is connected to the plurality of optical network units 120 through the optical distribution network 130 in a point to multi point manner. A direction from the optical line terminal 110 to the optical network units 120 is defined as a downlink direction, whereas a direction from the optical network units 120 to the optical line terminal 110 is defined as an uplink direction.

The passive optical network system 100 may be a communication network that implements data distribution between the optical line terminal 110 and the optical network unit 120 without any active component. For example, in a specific embodiment, the data distribution between the optical line terminal 110 and the optical network units 120 may be implemented through a passive optical component (for example, an optical splitter) in the optical distribution network 130. The passive optical network system 100 may be an asynchronous transfer mode passive optical network (ATM PON) system or a broadband passive optical network (BPON) system defined in the ITU-T G.983 standard, a Gigabit passive optical network (GPON) system defined in the ITU-T G.984 standard, an Ethernet passive optical network (EPON) defined in the IEEE 802.3ah standard, or a next generation passive optical network (NGA PON, such as an XGPON or a 10G EPON), all of which are incorporated in the present application by reference in their entireties.

The optical line terminal 110 is usually located at a central position (for example, a central office, CO), which may manage the plurality of optical network units 120, and transmit data between the optical network unit 120 and an upper-layer network (not shown in the drawings). Specifically, the optical line terminal 110 may act as an intermediary between the optical network units 120 and the upper-layer network to forward the data received from the upper-layer network to the optical network units 120, and forward the data received from the optical network units 120 to the upper-layer network. The specific structure configuration of the optical line terminal 110 may vary depending on the type of the passive optical network 100. For example, in an embodiment, the optical line terminal 110 may include an optical transceiver module, which is configured to send downlink optical signals to the optical network units 120, and receive uplink optical signals from the optical network units 120, where the downlink optical signals and the uplink optical signals may be transmitted through the optical distribution network. Furthermore, in a specific embodiment, the optical transceiver module may be independently configured as a pluggable optical module.

The optical network units 120 may be distributed at user side locations (for example, user premises). The optical network units 120 may be network devices that are configured to perform communication with the optical line terminal 110 and the users. Specifically, the optical network unit 120 may act as an intermediary between the optical line terminal 110 and the users. For example, the optical network units 120 may forward the data received from the optical line terminal 110 to the users, and forward the data received from the users to the optical line terminal 110. It should be understood that, the optical network unit 120 has structure similar to an optical network terminal (Optical Network Terminal, ONT). Therefore, in the solutions provided in the present application, the optical network unit can be replaced by the optical network terminal, and vice versa.

The optical distribution network 130 may be a data distribution system, which may include fiber, optical couplers, optical splitters and/or other devices. In an embodiment, the fibers, the optical couplers, the optical splitters and/or other devices may be passive optical components. Specifically, the fibers, the optical couplers, the optical splitters and/or other devices may be components that do not require any power to distribute data signals between the optical line terminal 110 and the optical network unit 120. In addition, in other embodiments, the optical distribution network 130 may further include one or more processing devices, for example, optical amplifiers or relay devices (Relay device). Moreover, the optical distribution network 130 may specifically extend from the optical line terminal 110 to the plurality of optical network units 120, and may also be configured as any other point to multi point structures.

Referring also to FIG. 2, in an embodiment, the optical line terminal 110 may include a service processing module 111, an optical transceiver module 112 and an optical coupler 113. The optical transceiver module 112 may include a transmitter sub-module 121 and a test sub-module 122, where the transmitter sub-module 121 and the test sub-module 122 are coupled to a trunk fiber of the optical distribution network 130 through the optical coupler 113. In one aspect, the optical coupler 113 may output optical signals sent by the transmitter sub-module 121 to the trunk fiber, in one specific embodiment, optical signals sent by the transmitter sub-module 121 usually may include the downlink data sent by the optical line terminal 110 to the optical network units 120, and during the test period on the optical line terminal, the optical signals sent by the transmitter sub-module 121 may further include a test signal for performing the optical line detection, where the test signal may be superimposed to the downlink data. In another aspect, during the test period, the optical coupler 113 may further provide a reflection signal returned from an optical fiber link of the passive optical network 100 to the test sub-module 122, where the OTDR test signal is reflected at the optical fiber link of the passive optical network 100 and thereby forming the reflection signal.

Definitely, it should be understood that, the optical transceiver module 112 may further include a receiver sub-module (not shown in the drawings); the optical coupler 113 may further provide uplink optical signals sent by the plurality of optical network units 120 to the receiver sub-module; and the receiver sub-module may perform optical-to-electrical conversion on the uplink optical signals and then output the uplink optical signals to the service processing module 111 for signal processing.

In an embodiment, as shown in FIG. 2, the transmitter sub-module 121 may include an optical source 123, an optical source driver 124 and a photodiode detector 125, where the optical source 123 may be a laser diode (Laser Diode, LD); the optical source driver 124 may be a laser diode driver (Laser Diode Driver, LDD); the photodiode detector 125 may be a monitor photodiode detector (Monitor Photodiode Detector, mPD). The optical source driver 124 is connected between the service processing module 111 and the optical source 123, and may modulate the downlink data provided by the service processing module 111 to the output light of the optical source 123, and during the test period, the optical source driver 124 may further superimpose the OTDR test signal provided by the test sub-module 124 to the downlink data, and modulate the superimposed signal to the output light of the optical source 123. The optical source 123 is connected between the laser diode driver 124 and the optical coupler 113, and may output the output light that bears the downlink data or the superimposed signal to the optical distribution network 130 through the optical coupler 113.

In addition, the photodiode detector 125 may be connected between the optical source 123 and the optical source driver 124, and may be configured to detect the output light of the optical source 123, convert the output light into a corresponding optical current through optical-to-electrical conversion, and provide the optical current to the optical source driver 124, so as to enable the optical source driver 124 to acquire an output optical power monitoring result of the optical source 123. In normal communication time period, the output light of the optical source 123 does not bear the OTDR test signal that is provided by the test sub-module 122, and the optical source driver 124 may adjust a bias current of the optical source 123 according to the output optical power monitoring result, thereby implementing the automatic power control of the optical source 123. During the test period, the output light of the optical source 123 bears the superimposed signal including the downlink data and the OTDR test signal, and the optical source driver 124 may ignore the output optical power monitoring result, and control the bias current of the optical source 123 to keep unchanged.

In a specific embodiment, when the test sub-module 122 starts an OTDR test, the optical source driver 124 may receive a preset test control signal from a upper-layer main control chip, and the preset control signal may be a valid OTDR test control signal (that is, an OTDR_TEST control signal). However, when the OTDR test is not started or the test is ended, the optical source driver 124 cannot receive the preset test control signal, which is equivalent to that at this time, the optical source driver receives an invalid OTDR_TEST control signal. Therefore, the optical source driver 124 may judge whether it is currently a test period through detecting whether the OTDR_TEST control signal is valid, and then judge whether the output optical power monitoring result needs to be ignored.

The test sub-module 122 may include an OTDR test controller 126 and an OTDR detector 127. The OTDR test controller 126 is connected to the service processing module 111 through a communication interface, and is further connected to the optical source driver 124. The OTDR detector 127 is connected between the OTDR test controller 126 and the optical coupler 113. When the test is initiated, the OTDR test controller 126 may receive an OTDR test command from the service processing module 111 through the communication interface, and correspondingly start the OTDR test and provide the OTDR test signal for the optical source driver 124. Furthermore, as described in the foregoing, during the test period, the OTDR test signal may be modulated to the output light of the optical source 123 and then output to the optical distribution network 130 through the optical coupler 113, and the OTDR test signal may be reflected at each test point of the optical fiber link and correspondingly reflection signals are generated, the reflection signals may further return to the optical coupler 113. The OTDR detector 127 may collect the reflection signals from the optical coupler 113 and provide the reflected signals to the OTDR test controller 126 as the test data. After the test is completed, the OTDR test controller 126 stops providing the OTDR test signal to the optical source driver 124, and the service processing module 111 may extract the test data from the OTDR test controller 126 through the communication interface and perform a preset OTDR algorithm calculation on the test data. Further, a corresponding OTDR test curve may be illustrated by the service processing module 111 or other functional modules (such as an upper-layer software module) of the optical line terminal 110 according to a calculation result, and the OTDR test curve may be used for fault detection and location.

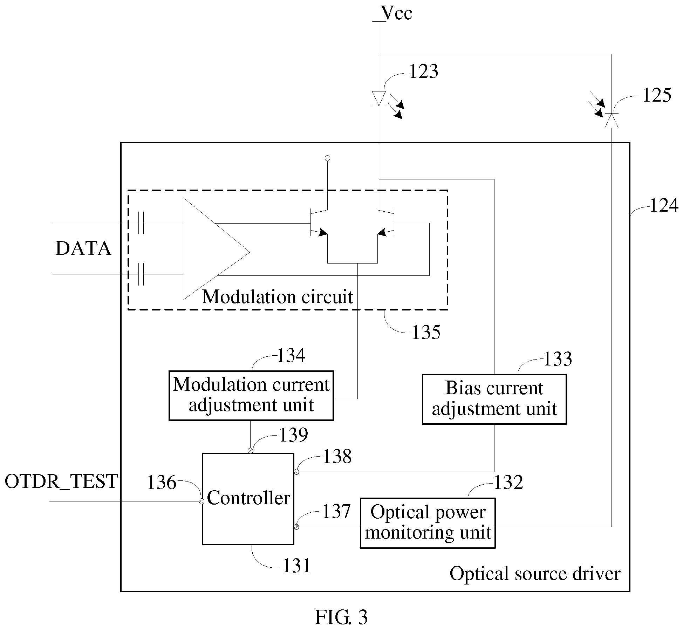

Referring also to FIG. 3, FIG.3 is a schematic circuit diagram of the optical source driver 124 according to an embodiment of the present application. To better understand this embodiment, FIG. 3 further illustrates a connection relationship between the optical source driver 124 and the optical source 123 and the photodiode detector 125.

The optical source driver 124 may include a controller 131, an optical power monitoring unit 132, a bias current adjustment unit 133, a modulation current adjustment unit 134 and a modulation circuit 135. The controller 131 includes a test control terminal 136, an optical power monitoring terminal 137, a bias current control terminal 138 and a modulation current control terminal 139. The test control terminal 136 may be configured to receive the OTDR_TEST control signal from the upper-layer main control chip. When the passive optical network 100 is in a normal communication state, the OTDR_TEST control signal received by the test control end 136 is a valid signal, and when the passive optical network 100 is in a test period, the OTDR_TEST control signal received by the test control end 136 is an invalid signal. The optical power monitoring terminal 137, the bias current control terminal 138 and the modulation current control terminal 139 are connected to the optical power monitoring unit 132, the bias current adjustment unit 133 and the modulation current adjustment unit 134, respectively.

The modulation circuit 135 may be connected between the modulation current adjustment unit 134 and the optical source 123, and may modulate the downlink data or the superimposed signal including the test signal and the downlink data to the output light of the optical source 123 through a differential switch pair. The modulation current adjustment unit 134 may adjust the modulation current of the optical source 123 according to a modulation current control signal received from the modulation current control terminal 139 of the controller 131.

The optical power monitoring unit 132 may be further connected to the photodiode detector 125, and the optical power monitoring unit 132 may acquire the output optical power of the optical source 123 according to the optical current that is provided by the photodiode detector 125 and corresponds to the output light of the optical source 123, and provide the output optical power monitoring result for the controller 131 through the optical power monitoring terminal 137.

The bias current adjustment unit 133 is further connected to the optical source 123. When the passive optical network 100 is in a normal communication state, the OTDR_TEST control signal received by the controller 131 is invalid. At this time, the optical power monitoring unit 132, the controller 131 and the bias current adjustment unit 134 cooperatively form an APC loop which may be configured to implement the automatic power control of the optical source 123. The controller 131 may, based on the output optical power monitoring result that is acquired from the optical power monitoring unit 132, output the bias current control signal to the bias current adjustment unit 133 through the bias current control terminal 138, and control the bias current adjustment unit 133 to adjust the bias current of the optical source 123, so as to implement the automatic power control. Specifically, when the output optical power monitoring result indicates that the output optical power is less than a preset range, the controller 131 may control the bias current adjustment unit 133 to increase the bias current of the optical source 123. When the output optical power monitoring result indicates that the output optical power is greater than the preset range, the controller 131 may control the bias current adjustment unit 133 to reduce the bias current of the optical source 123. When the output optical power monitoring result indicates that the output optical power falls within the preset range, the controller 131 may control the bias current adjustment unit 133 not to adjust the bias current of the optical source 123, so that the optical source 123 keeps the current output optical power. Through the automatic power control in the foregoing solutions, the output optical power of the optical source 123 may be stabilized in a target range, thereby ensuring the power budget of the network link.

When the passive optical network starts the OTDR test, the controller 131 receives a valid OTDR_TEST control signal. At this time, the controller 131 ignores the output optical power monitoring result under the control of the OTDR_TEST control signal, that is, the APC loop is disabled and the bias current adjustment unit 133 is controlled to provide a fixed bias current to the optical source 123 to keep the bias current of the optical source 123 maintaining at a current value when the OTDR test is started (that is, when the APC loop is opened), until the OTDR test is ended. That is to say, during the OTDR test period, although that the OTDR test signal is superimposed to the downlink data may cause fluctuations on the output optical power of the optical source 123, the optical source driver 124 at this time stops the automatic adjustment to the output optical power by the APC loop under the control of the OTDR_TEST control signal, thereby avoiding the problem that the signal of the OTDR test signal is significantly weakened or even submerged effectively, and ensuring the normal OTDR test and fault location.

After the OTDR test is completed and the normal communication state is entered, the controller 131 may control the APC loop to be closed-loop again, and therefore the optical source driver 124 may recover the foregoing automatic output optical power control of the optical source 123.

It can be seen that, in the solutions provided by the embodiment of the present application, the APC loop for the bias current of the optical source 123 is controlled to be open-loop during the OTDR test period, and the APC loop is controlled to be closed-loop after the test is completed, and the bias current of the optical source 123 is stabilized at a preset target value when the APC loop is switched between the open-loop and the closed loop. Therefore, the submersion of the OTDR test signal caused by the weakening of the intensity of the OTDR test signal due to the automatic power control of the APC loop during the test period can be avoided effectively, and thereby ensuring the normal OTDR test and fault location.

The operation of the foregoing optical source driver 124 is briefly summarized, with reference to the flow chart shown in IFG. 4, as follows.

After the system is powered up (step S0), the controller 131 first detects whether the OTDR_TEST control signal is valid (step S1). If the OTDR_TEST control signal is valid, the controller 131 controls the APC loop to be open-loop, and controls the bias current adjustment unit 133 to provide a fixed bias current to the optical source 123 (step S2). If the OTDR_TEST control signal is invalid, the controller 131 maintains a closed-loop state of the APC loop, and judges whether the output optical power of the optical source 123 is within the preset range according to the output optical power monitoring result that is provided by the optical power monitoring unit 132 (step S3). If the output optical power is within the preset range, the controller 131 controls the bias current adjustment unit 133 to maintain the current bias current of the optical source 123 (step S4). If the output optical power is not within the preset range, the controller 131 further continues to judge whether the output optical power exceeds the preset range (step S5). If the output optical power exceeds the preset range, the controller 131 controls the bias current adjustment unit 133 to reduce the bias current of the optical source 123 (step S6), and if the output optical power is less than the preset range, the controller 131 controls the bias current adjustment unit 133 to increase the bias current of the optical source 123 (step S7).

Through the above description of the implementation manners, persons skilled in the art may clearly understand that the present invention may be implemented through software on a necessary hardware platform, and definitely may also be implemented completely through hardware. Based on such understanding, the above technical solutions or the part that makes contributions to the prior art may be embodied in the form of a software product. The computer software product may be stored in a readable storage medium, such as a ROM/RAM, a magnetic disk, or an optical disk, and includes several instructions to instruct computer device (for example, a personal computer, a server, or a network device) to perform the method described in the embodiments or in some parts of the embodiments of the present invention.

The above descriptions are merely exemplary embodiments of the present invention, but the protection scope of the present invention is not limited thereto. Any modification, equivalent replacement, readily conceivable by persons skilled in the art within the technical solutions disclosed in the present invention should fall within the protection scope of the present invention. Therefore, the protection scope of the present invention is subject to the appended claims.

The invention may also refer to one or more optional further embodiments:
1. A method for controlling optical power, comprising:
   monitoring output optical power of an optical source, and judging whether a preset test control signal is received;
   when the preset test control signal is not received, modulating a data signal to output light of the optical source, and adjusting a bias current of the optical source according to an output optical power monitoring result of the optical source to implement automatic power control; and
   when the preset test control signal is received, starting a test and superimposing a test signal to the data signal to form a superimposed signal, and modulating the superimposed signal to the output light of the optical source, wherein the output optical power monitoring result of the optical source is ignored during the test period to maintain the bias current of the optical source at a preset target value.
2. The method for controlling optical power according to optional further embodiment 1, wherein the preset control signal is a valid optical time domain reflectometer, OTDR, test control signal.
3. The method for controlling optical power according to optional further embodiment 2, wherein when an OTDR test is started, an automatic power control loop, under the control of the preset test control signal, is controlled to be open-loop to pause the automatic power control, and during the OTDR test period, the bias current of the optical source is maintained at a current value when the OTDR test is started.
4. The method for controlling optical power according to optional further embodiment 3, further comprising: after the OTDR test is completed, controlling the automatic power control loop to be closed-loop again, and recovering the automatic optical power adjustment.
5. An optical source driver, comprising: a controller, a bias current adjustment unit and an optical power monitoring unit, wherein both the bias current adjustment unit and the optical power monitoring unit are connected to the controller;
   the optical power monitoring unit is configured to monitor output optical power of an optical source and provide an output optical power monitoring result to the controller; and
   the controller is configured to detect whether a preset test control signal is received; when the preset test control signal is not received, control the bias current adjustment unit to adjust a bias current of the optical source according to the output optical power monitoring result to implement automatic power control; and when the preset test control signal is received, control the bias current adjustment unit to maintain the bias current of the optical source at a preset target value by ignoring the output optical power monitoring result.
6. The optical source driver according to optional further embodiment 5, wherein the preset control signal is a valid optical time domain reflectometer, OTDR, test control signal.
7. The optical source driver according to optional further embodiment 6, wherein when an OTDR test is not started, the optical power monitoring unit, the controller and the bias current adjustment unit cooperatively form an automatic power control loop; and the controller is further configured to control the automatic power control loop to be open-loop under the control of the preset test control signal when the OTDR test is started, and control the bias current adjustment unit to maintain the bias current of the optical source at a current value when the OTDR test is started during the OTDR test period.
8. The optical source driver according to optional further embodiment 7, wherein the controller is further configured to control the automatic optical control loop to be closed-loop again after the OTDR test is completed, to recover the automatic power adjustment.
9. The optical source driver according to optional further embodiment 7, further comprising: a modulation circuit, configured to modulate a data signal to output light of the optical source when the OTDR test is not started,, and superimpose a test signal to the data signal to form a superimposed signal and modulate the superimposed signal to the output light of the optical source during the OTDR test period.
10. An optical transceiver module, comprising an optical source, an optical source driver and a test controller, wherein
   the test controller is connected to the optical source driver, and is configured to provide a test signal for the optical source driver during a test period; and
   the optical source driver is configured to acquire an output optical power monitoring result of the optical source; when a preset test control signal is not received, modulate a data signal to output light of the optical source, and adjust a bias current of the optical source according to an output optical power monitoring result to implement automatic power control; and when the preset test control signal is received, start a test and superimpose the test signal to the data signal to form a superimposed signal and modulate the superimposed signal to the output light of the optical source, and maintain the bias current of the optical source at a preset target value by ignoring the output optical power monitoring result of the optical source during the test period.
11. The optical transceiver module according to optional further embodiment 10, wherein the preset control signal is a valid optical time domain reflectometer, OTDR, test control signal.
12. The optical source driver according to optional further embodiment 11, wherein the optical source driver is further configured to form an internal automatic power control loop when an OTDR test is not started,, and control the automatic power control loop to be open-loop under the control of the preset test control signal when the OTDR test is started, and maintain the bias current of the optical source at a current value when the OTDR test is started during the OTDR test period.
13. The optical source driver according to optional further embodiment 11, further comprising an OTDR detector, wherein the OTDR detector is configured to collect reflection signals returned when the test signal is reflected in an optical network during the OTDR test period, and provide the reflection signals as OTDR test data for the test controller.
14. An optical line terminal, comprising a service processing module and an optical transceiver module, wherein the optical transceiver module is an optical transceiver module of any one of optional further embodiment 10-13, and the service processing module is configured to provide a preset test control signal to the optical transceiver module, collect test data and correspondingly perform fault detection after a test is completed.

## Claims

1. A method for controlling optical power, comprising:
monitoring output optical power of an optical source, and judging whether a preset test control signal is received;
when the preset test control signal is not received, outputting light of the optical source, and adjusting a bias current of the optical source according to an output optical power monitoring result of the optical source to implement automatic power control, wherein the output light of the optical source does not comprises a test signal, but comprise a data signal;
when the preset test control signal is received, starting a test and outputting light of the optical source, wherein the output light of the optical source comprises a test signal and a data signal, wherein the output optical power monitoring result of the optical source is ignored during the test period to maintain the bias current of the optical source at a preset target value; and
wherein the preset control signal is a valid optical time domain reflectometer, OTDR, test control signal.

2. The method for controlling optical power according to claim 1, wherein when an OTDR test is started, an automatic power control loop, under the control of the preset test control signal, is controlled to be open-loop to pause the automatic power control, and during the OTDR test period, the bias current of the optical source is maintained at a current value when the OTDR test is started.

3. The method for controlling optical power according to claim 2, further comprising: after the OTDR test is completed, controlling the automatic power control loop to be closed-loop again, and recovering the automatic optical power adjustment.

4. An optical transceiver module, comprising an optical source, an optical source driver and a test controller, wherein
the test controller is connected to the optical source driver, and is configured to provide a test signal for the optical source driver during a test period;
the optical source driver is configured to acquire an output optical power monitoring result of the optical source; when a preset test control signal is not received, output light of the optical source, and adjust a bias current of the optical source according to an output optical power monitoring result to implement automatic power control, wherein the output light of the optical source does not comprises a test signal, but comprise a data signal; and when the preset test control signal is received, start a test and output light of the optical source, wherein the output light of the optical source comprises a test signal and a data signal, and maintain the bias current of the optical source at a preset target value by ignoring the output optical power monitoring result of the optical source during the test period; and
wherein the preset control signal is a valid optical time domain reflectometer, OTDR, test control signal.

5. The optical source driver according to claim 4, wherein the optical source driver is further configured to form an internal automatic power control loop when an OTDR test is not started,, and control the automatic power control loop to be open-loop under the control of the preset test control signal when the OTDR test is started, and maintain the bias current of the optical source at a current value when the OTDR test is started during the OTDR test period.

6. The optical source driver according to claim 4, further comprising an OTDR detector, wherein the OTDR detector is configured to collect reflection signals returned when the test signal is reflected in an optical network during the OTDR test period, and provide the reflection signals as OTDR test data for the test controller.

7. An optical line terminal, comprising a service processing module and an optical transceiver module, wherein the optical transceiver module is an optical transceiver module of any one of claims 4-6, and the service processing module is configured to provide a preset test control signal to the optical transceiver module, collect test data and correspondingly perform fault detection after a test is completed.

## Patentansprüche

1. Verfahren zur Steuerung der optischen Leistung, umfassend:
Überwachen der optischen Ausgangsleistung einer optischen Quelle und Beurteilen, ob ein voreingestelltes Teststeuersignal empfangen wird;
wenn das voreingestellte Teststeuersignal nicht empfangen wird, Ausgeben von Licht der optischen Quelle und Einstellen eines Vorspannungsstroms der optischen Quelle gemäß einem optischen Ausgangsleistungs-Überwachungsergebnis der optischen Quelle, um eine automatische Leistungssteuerung zu implementieren, wobei das Ausgangslicht der optischen Quelle kein Testsignal umfasst, sondern ein Datensignal;
wenn das voreingestellte Teststeuersignal empfangen wird, Starten eines Tests und Ausgeben von Licht der optischen Quelle, wobei das Ausgangslicht der optischen Quelle ein Testsignal und ein Datensignal umfasst, wobei das optische Ausgangsleistungs-Überwachungsergebnis der optischen Quelle während der Testdauer ignoriert wird, um den Vorspannungsstrom der optischen Quelle auf einem voreingestellten Zielwert zu halten; und
wobei das voreingestellte Steuersignal ein gültiges optisches Zeitbereichsreflektometer (Optical Time Domain Reflectometer, OTDR)-Teststeuersignal ist.

2. Verfahren zur Steuerung der optischen Leistung nach Anspruch 1, wobei bei einem Start eines OTDR-Tests eine automatische Leistungsregelschleife, unter der Steuerung des voreingestellten Teststeuersignals, gesteuert wird, um eine offene Schleife zu bilden, um die automatische Leistungssteuerung zu unterbrechen und, während der OTDR-Testdauer, der Vorspannungsstrom der optischen Quelle bei dem Start des OTDR-Tests auf einem aktuellen Wert gehalten wird.

3. Verfahren zur Steuerung der optischen Leistung nach Anspruch 2, ferner umfassend:
nachdem der OTDR-Test abgeschlossen ist, Steuern der automatischen Leistungsregelschleife, um wieder eine geschlossene Schleife zu bilden, und
Wiederherstellen der automatischen optischen Leistungseinstellung.

4. Optisches Transceivermodul mit einer optischen Quelle, einem optischen Quellentreiber und einer Teststeuerung, wobei:
die Teststeuerung mit dem optischen Quellentreiber verbunden ist und konfiguriert ist, um ein Testsignal für den optischen Quellentreiber während einer Testdauer bereitzustellen;
der optische Quellentreiber konfiguriert ist, um ein optisches Ausgangsleistungs-Überwachungsergebnis der optischen Quelle zu erfassen; wenn ein voreingestelltes Teststeuersignal nicht empfangen wird, Licht der optischen Quelle auszugeben und einen Vorspannungsstrom der optischen Quelle gemäß einem optischen Ausgangsleistungs-Überwachungsergebnis einzustellen, um eine automatische Leistungssteuerung zu implementieren, wobei das Ausgangslicht der optischen Quelle kein Testsignal umfasst, sondern ein Datensignal; und wenn das voreingestellte Teststeuersignal empfangen wird, einen Test zu starten und Licht der optischen Quelle auszugeben, wobei das Ausgangslicht der optischen Quelle ein Testsignal und ein Datensignal umfasst, und den Vorspannungsstrom der optischen Quelle auf einem voreingestellten Zielwert zu halten, indem das Ausgangsleistungs-Überwachungsergebnis der optischen Quelle während der Testdauer ignoriert wird; und
wobei das voreingestellte Steuersignal ein gültiges optisches Zeitbereichsreflektometer (Optical Time Domain Reflectometer, OTDR)-Teststeuersignal ist.

5. Optischer Quellentreiber nach Anspruch 4, wobei der optische Quellentreiber ferner konfiguriert ist, um eine interne automatische Leistungsregelschleife zu bilden, wenn ein OTDR-Test nicht gestartet wird, und die automatische Leistungsregelschleife zu steuern, um eine offene Schleife unter der Steuerung des voreingestellten Teststeuersignals zu bilden, wenn der OTDR-Test gestartet wird, und den Vorspannungsstrom der optischen Quelle auf einem voreingestellten Zielwert zu halten, wenn der OTDR-Test während der OTDR-Testdauer gestartet wird.

6. Optischer Quellentreiber nach Anspruch 4, ferner umfassend einen OTDR-Detektor, wobei der OTDR-Detektor konfiguriert ist, um Reflexionssignale zu sammeln, die zurückgegeben werden, wenn das Testsignal in einem optischen Netzwerk während der OTDR-Testdauer reflektiert wird, und die Reflexionssignale als OTDR-Testdaten für die Teststeuerung bereitzustellen.

7. Optisches Leitungsendgerät, umfassend ein Dienstverarbeitungsmodul und ein optisches Transceivermodul, wobei das optische Transceivermodul ein optisches Transceivermodul nach einem der Ansprüche 4-6 ist, und das Dienstverarbeitungsmodul konfiguriert ist, um ein voreingestelltes Teststeuersignal für das optische Transceivermodul bereitzustellen, Testdaten zu sammeln und eine Fehlererkennung entsprechend durchzuführen, nachdem ein Test abgeschlossen ist.

## Revendications

1. Procédé de régulation de puissance optique, comportant les étapes consistant à :
surveiller la puissance optique de sortie d'une source optique, et juger si un signal de commande de test prédéfini est reçu ou non;
lorsque le signal de commande de test prédéfini n'est pas reçu, délivrer une lumière de la source optique, et régler un courant de polarisation de la source optique en fonction d'un résultat de surveillance de puissance optique de sortie de la source optique pour mettre en oeuvre une régulation automatique de puissance, la lumière de sortie de la source optique ne comportant pas un signal de test, mais comportant un signal de données ;
lorsque le signal de commande de test prédéfini est reçu, commencer un test et délivrer une lumière de la source optique, la lumière de sortie de la source optique comportant un signal de test et un signal de données, le résultat de surveillance de puissance optique de sortie de la source optique étant ignoré pendant la période de test pour maintenir le courant de polarisation de la source optique à une valeur cible prédéfinie ; et
le signal de commande prédéfini étant un signal valide de commande de test de réflectomètre optique temporel, OTDR.

2. Procédé de régulation de puissance optique selon la revendication 1, **caractérisé en ce que**, lorsqu'un test d'OTDR est commencé, une boucle de régulation automatique de puissance, sous le contrôle du signal de commande de test prédéfini, est commandée de telle façon qu'elle soit en boucle ouverte pour suspendre la régulation automatique de puissance, et **en ce que**, pendant la période de test d'OTDR, le courant de polarisation de la source optique est maintenu à une valeur actuelle lorsque le test d'OTDR est commencé.

3. Procédé de régulation de puissance optique selon la revendication 2, comportant en outre les étapes consistant :
après que le test d'OTDR s'est achevé, à commander la boucle de régulation automatique de puissance de telle façon qu'elle soit de nouveau en boucle fermée, et
à récupérer le réglage automatique de puissance optique.

4. Module d'émetteur-récepteur optique, comportant une source optique, un excitateur de source optique et une commande de test, la commande de test étant reliée à l'excitateur de source optique, et étant configurée pour fournir un signal de test destiné à l'excitateur de source optique pendant une période de test ;
l'excitateur de source optique étant configuré pour acquérir un résultat de surveillance de puissance optique de sortie de la source optique ; lorsqu'un signal de commande de test prédéfini n'est pas reçu, délivrer une lumière de la source optique, et régler un courant de polarisation de la source optique en fonction d'un résultat de surveillance de puissance optique de sortie pour mettre en oeuvre une régulation automatique de puissance, la lumière de sortie de la source optique ne comportant pas un signal de test, mais comportant un signal de données ; et
lorsque le signal de commande de test prédéfini est reçu, commencer un test et délivrer une lumière de la source optique, la lumière de sortie de la source optique comportant un signal de test et un signal de données, et maintenir le courant de polarisation de la source optique à une valeur cible prédéfinie en ignorant le résultat de surveillance de puissance optique de sortie de la source optique pendant la période de test ; et
le signal de commande prédéfini étant un signal valide de commande de test de réflectomètre optique temporel, OTDR.

5. Excitateur de source optique selon la revendication 4, l'excitateur de source optique étant en outre configuré pour former une boucle interne de régulation automatique de puissance lorsqu'un test d'OTDR n'est pas commencé, et commander la boucle de régulation automatique de puissance de telle façon qu'elle soit en boucle ouverte sous le contrôle du signal de commande de test prédéfini lorsque le test d'OTDR est commencé, et maintenir le courant de polarisation de la source optique à une valeur actuelle lorsque le test d'OTDR est commencé pendant la période de test d'OTDR.

6. Excitateur de source optique selon la revendication 4, comportant en outre un détecteur d'OTDR, le détecteur d'OTDR étant configuré pour recueillir des signaux de réflexion renvoyés lorsque le signal de test est réfléchi dans un réseau optique pendant la période de test d'OTDR, et fournir les signaux de réflexion en tant que données de test d'OTDR pour la commande de test.

7. Terminal de ligne optique, comportant un module de traitement de service et un module d'émetteur-récepteur optique, le module d'émetteur-récepteur optique étant un module d'émetteur-récepteur optique selon l'une quelconque des revendications 4 à 6, et le module de traitement de service étant configuré pour fournir un signal de commande de test prédéfini au module d'émetteur-récepteur optique, recueillir des données de test et effectuer de façon correspondante une détection de pannes après qu'un test s'est achevé.
